# FASCICULE DE BREVET EUROPEEN

(11) **EP 4 528 798 B1**
(45) Date de publication et mention de la délivrance du brevet: **18.11.2026**
(21) Numéro de dépôt: 24198204.0
(22) Date de dépôt: 03.09.2024
(51) Int. Cl.: H10W 72/00, H10W 72/20, H10W 74/10, H10P 54/00

(54) **COMPOSANT ÉLECTRONIQUE**
ELEKTRONISCHE KOMPONENTE
ELECTRONIC COMPONENT

(30) Priorité: 15.09.2023 FR 2309779
(43) Date de publication de la demande: 26.03.2025
(73) Titulaire: STMicroelectronics International N.V., 1228 Plan-les-Ouates, Geneva (CH)
(72) Inventeur: DE CRUZ, Michael, 37380 MONNAIE (FR); BARREAU, Laurent, 37300 JOUE LES TOURS (FR)
(74) Mandataire: Cabinet Beaumont

(56) Documents cités:
- US-A1- 2006 033 214
- US-A1- 2019 232 438
- US-A1- 2022 375 840

## Description

### Domaine technique

La présente description concerne de façon générale les composants électroniques et leurs procédés de fabrication, plus particulièrement les composants électroniques comprenant au moins une puce de circuit intégré mise sous boîtier et les procédés de fabrication de tels composants.

### Technique antérieure

Des composants électroniques comprenant au moins une puce de circuit intégré mise sous boîtier ont été proposés. Il existe en particulier des composants comprenant un boîtier de type CSP (de l'anglais « Chip-Scale Package » - boîtier présentant des dimensions similaires à celle de la puce). Ces composants sont généralement montés en surface, sur une carte de circuit imprimé, par un procédé de brasage mettant en œuvre des étapes de fusion puis de solidification d'une pâte ou d'un flux de brasage à base d'un alliage sans plomb, par exemple un alliage d'étain, d'argent et de cuivre (alliage Sn-Ag-Cu) également connu sous l'acronyme SAC. Pour assembler le composant électronique à la carte de circuit imprimé, une température supérieure au point de fusion de l'alliage, égal à environ 218 °C dans le cas de l'alliage SAC, est appliquée afin de provoquer la fusion du matériau de brasage. L'ensemble est ensuite refroidi pour solidifier le matériau de brasage, fixant ainsi mécaniquement le composant à la carte.

Toutefois, les composants électroniques existants comprenant un boîtier CSP présentent divers inconvénients. En particulier, les procédés connus de fabrication de composants électroniques mettant en œuvre l'alliage SAC font apparaître des problèmes de pontage, ou d'interconnexion, involontaire entre des puces de circuit intégré adjacentes lors d'une étape de refusion du matériau de brasage préalable à une étape de découpe visant à individualiser les puces de circuit intégré.

Par ailleurs, dans certains domaines d'application tels que la fabrication automobile, il serait souhaitable de disposer de composants dotés de flancs mouillables permettant de faciliter des étapes d'inspection après brasage. Toutefois, une étape de refusion de flancs revêtus de l'alliage SAC lors de l'assemblage conduirait à un phénomène indésirable d'affaissement ou d'écoulement de cet alliage sur la carte de circuit imprimé.

En outre, dans un cas où le boîtier du composant entoure plusieurs puces de circuit intégré, dont par exemple une puce ASIC (de l'anglais « Application-Specific Integrated Circuit » - circuit intégré propre à une application), superposées et interconnectées par des billes de soudure, ces billes sont généralement composées d'un alliage métallique, par exemple un alliage d'or et d'étain, présentant un point de fusion supérieur à celui de l'alliage utilisé pour le brasage, par exemple l'alliage SAC, afin d'empêcher une refusion des billes de soudure lors du brasage du composant sur la carte. L'alliage d'or et d'étain étant particulièrement onéreux, il serait souhaitable de lui trouver un matériau de substitution présentant un coût de revient inférieur. Dans ce contexte, US2006033214A1 décrit un assemblage flip-chip utilisant des couches de soudure à bas point de fusion de part et d'autre d'un bump à haut point de fusion et une résine de scellement. US2019232438A1 décrit une pâte à braser à base de poudre de soudure et de flux époxy avec diluant réactif, destinée à former une liaison conductrice renforcée par une résine durcie.

### Résumé de l'invention

Il existe un besoin de pallier tout ou partie des inconvénients des composants électroniques connus et de leurs procédés de fabrication.

L'invention est définie par la revendication 1. Les revendications dépendantes couvrent des modes de réalisation et variantes de l'invention.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figure 1A, figure 1B, figure 1C, figure 1D et figure 1E sont des vues en coupe, schématiques et partielles, illustrant des étapes successives d'un procédé de fabrication d'un composant électronique selon un mode de réalisation ; et
la figure 2 est une vue en coupe, schématique et partielle, d'un dispositif électronique comprenant un composant électronique selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications et systèmes dans lesquels peuvent être prévus des composants électroniques ne sont pas détaillés, les modes de réalisation et variantes décrits étant compatibles avec les applications et systèmes usuels comprenant un ou plusieurs composants électroniques, moyennant éventuellement des adaptations à la portée de la personne du métier à la lecture de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

Dans la description qui suit, les qualificatifs « isolant » et « conducteur » signifient respectivement, sauf précision contraire, électriquement isolant et électriquement conducteur.

Dans la présente description, lorsqu'une teneur d'un alliage métallique en un élément chimique, par exemple un élément métallique, est exprimée en pourcent (%), il s'agit, sauf mention contraire, d'une teneur massique, exprimée en pourcentage de la masse totale de l'alliage.

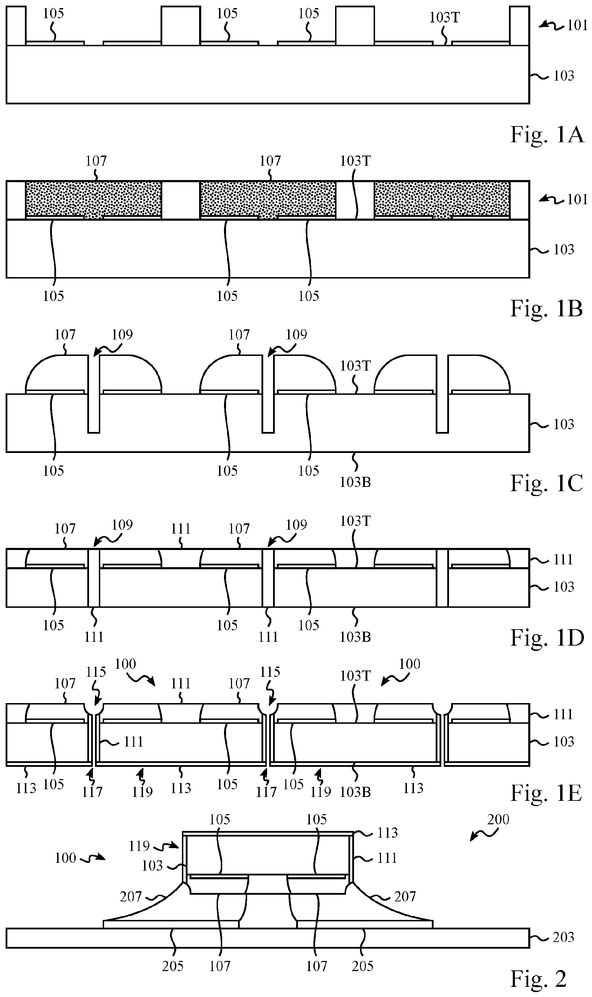

Les figure 1A, figure 1B, figure 1C, figure 1D et figure 1E sont des vues en coupe, schématiques et partielles, illustrant des étapes successives d'un procédé de fabrication d'un composant électronique 100 selon un mode de réalisation.

La figure 1A illustre plus précisément une structure obtenue à l'issue d'une étape dans laquelle un masque 101 est disposé sur et en contact avec une face 103T d'un substrat 103 (la face supérieure du substrat 103, dans l'orientation de la figure 1A).

Dans l'exemple illustré, le masque 101 forme une couche discontinue s'étendant latéralement sur et en contact avec la face 103T du substrat 103. Dans cet exemple, le masque 101 comprend des parties disjointes délimitant latéralement des ouvertures. Le masque 101 est par exemple un masque de sérigraphie. À titre d'exemple, le masque 101 est en un matériau isolant, par exemple une résine.

Le substrat 103 est par exemple une plaquette ou un morceau de plaquette en un matériau semiconducteur, par exemple le silicium ou le nitrure de germanium (GaN). Bien que cela n'ait pas été détaillé en figure 1A, le substrat 103 comprend par exemple au moins un composant électronique unitaire, par exemple au moins un composant électronique unitaire de puissance. Chaque composant électronique unitaire comprend par exemple au moins un élément choisi parmi une diode, un thyristor, un triac, un transistor, une charge résistive, capacitive ou inductive, etc.

Dans l'exemple représenté, des éléments de reprise de contact 105 sont situés sur et en contact avec des parties de la face 103T du substrat 103 non revêtues du masque 101. Les éléments de reprise de contact 105 sont par exemple connectés à des électrodes de conduction et/ou de commande du ou des composants électroniques unitaires formés dans le substrat 103. À titre d'exemple, les éléments de reprise de contact 105 sont des plots conducteurs, par exemple des plots en un métal, par exemple le cuivre, ou en un alliage métallique. Le masque 101 est par exemple aligné par rapport à la position des éléments de reprise de contact 105 sur la face 103T du substrat 103. Dans l'exemple illustré en figure 1A, deux éléments de reprise de contact 105 sont situés dans chaque ouverture du masque 101. Cet exemple n'est toutefois pas limitatif, le nombre d'éléments de reprise de contact 105 situés dans chaque ouverture du masque 101 pouvant, à titre de variante, être différent de deux.

La figure 1B illustre plus précisément une structure obtenue, à partir de la structure de la figure 1A, à l'issue d'une étape dans laquelle des régions conductrices 107 sont formées dans les ouvertures du masque 101.

Dans l'exemple représenté, les régions conductrices 107 comblent les ouvertures du masque 101, c'est-à-dire remplissent intégralement tous les espaces libres s'étendant latéralement entre les parties du masque 101. Dans cet exemple, les régions conductrices 107 sont bordées par le masque 101, les flancs de chaque région conductrice 107 étant revêtus par des parties du masque 101. Dans l'exemple représenté, les régions conductrices 107 revêtent les éléments de reprise de contact 105 et des parties de la face 103T du substrat 103 non revêtues du masque 101 ou des éléments de reprise de contact 105. Dans l'exemple illustré, chaque région conductrice 107 revêt deux éléments de reprise de contact 105. Dans l'exemple représenté, les régions conductrices 107 affleurent la face du masque 101 opposée au substrat 103 (la face supérieure du masque 101, dans l'orientation de la figure 1B).

Les régions conductrices 107 sont par exemple en un matériau de brasage, par exemple une pâte de brasage. À ce stade du procédé, le matériau des régions conductrices 107 comprend par exemple un alliage métallique, par exemple sous forme de billes ou de microbilles d'alliage métallique dispersées dans un matériau visqueux ou pâteux.

Selon un mode de réalisation, l'alliage métallique contenu dans les régions conductrices 107 comprend majoritairement du bismuth (Bi). L'alliage présente par exemple plus précisément une teneur en bismuth supérieure à 80 %, par exemple égale à environ 90 %. L'alliage comprend par exemple en outre au moins un élément d'addition choisi parmi l'argent (Ag), le nickel (Ni) et l'étain (Sn). Dans ce cas, l'alliage présente par exemple une teneur en chaque élément d'addition inférieure à 10 %, par exemple égale à environ 5 %. À titre d'exemple, l'alliage métallique des régions conductrices 107 présente une teneur en bismuth égale à environ 90 %, une teneur en argent égale à environ 5 % et une teneur en nickel égale à environ 5 %. L'alliage présente par exemple un point de fusion compris entre 270 et 290 °C.

La figure 1C illustre plus précisément une structure obtenue, à partir de la structure de la figure 1B, à l'issue d'une étape dans laquelle le masque 101 est éliminé, les régions conductrices 107 sont soumises à une refusion et des tranchées 109 sont formées dans les régions conductrices 107 et le substrat 103.

Dans l'exemple illustré en figure 1C, le masque 101 est intégralement retiré.

Dans l'exemple représenté, les régions conductrices 107 ont été soumises à un phénomène de refusion, par exemple par la mise en œuvre d'une opération de chauffage visant à exposer la structure à une température supérieure au point de fusion de l'alliage métallique contenu dans les régions conductrices 107. Dans le cas où l'alliage se présente sous forme de billes ou de microbilles dispersées dans un flux, cette opération conduit à la fusion des billes ou des microbilles et à l'élimination du flux. À l'issue de cette opération, chaque région conductrice 107 est sensiblement constituée de l'alliage métallique. Dans l'exemple représenté, les régions conductrices 107 présentent, après refusion, des flancs incurvés ou arrondis. À titre d'exemple, les flancs des régions conductrices 107 présentent une courbure qui dépend de la tension superficielle de l'alliage métallique à l'état liquide.

Dans l'exemple illustré, les tranchées 109 sont sensiblement alignées par rapport au centre des régions 107. Dans l'orientation de la figure 1C, chaque tranchée 109 s'étend verticalement, depuis la face supérieure de l'une des régions conductrices 107, à travers la région 107 et pénètre dans l'épaisseur du substrat 103. Dans l'exemple représenté, les tranchées 109 ne débouchent pas du côté d'une face 103B du substrat 103 (la face inférieure du substrat 103, dans l'orientation de la figure 1C) opposée à la face 103T. Chaque tranchée 109 est par exemple interposée latéralement entre deux éléments de reprise de contact 105 initialement revêtus par une même région 107. À titre d'exemple, les tranchées 109 sont formées par découpe, par exemple par sciage, du côté de la face 103T du substrat 103.

Dans l'exemple représenté, le ou les composants électroniques unitaires formés dans le substrat 103 et destinés à faire partie d'un même composant électronique 100 sont délimités latéralement par les tranchées 109. Les tranchées 109 présentent par exemple, en vue de dessus, une forme de quadrillage dont chaque case correspond à un futur composant électronique 100. Dans l'exemple illustré, chaque élément de reprise de contact 105 est revêtu d'une partie de l'une des régions conductrices 107 disjointe des parties des régions conductrices 107 revêtant les autres éléments de reprise de contact 105. Dans l'exemple représenté en figure 1C, chaque futur composant électronique 100 comprend deux éléments de reprise de contact 105 revêtus respectivement de deux parties de régions conductrices 107 disjointes.

La figure 1D illustre plus précisément une structure obtenue, à partir de la structure de la figure 1C, à l'issue d'une étape dans laquelle une couche isolante 111 est déposée du côté de la face 103T du substrat 103 et dans laquelle la structure est amincie du côté des faces 103T et 103B du substrat 103.

Dans l'exemple représenté, la couche isolante 111 comble, c'est-à-dire remplit intégralement, les tranchées 109 et tous les espaces libres s'étendant latéralement entre les régions 107. À titre d'exemple, la couche isolante 111 est en une résine, par exemple une résine de moulage destinée à former un boîtier autour de chaque futur composant électronique 100.

Dans l'exemple illustré, la structure est amincie, par exemple par meulage, du côté de la face 103T du substrat 103 de sorte à réduire l'épaisseur des régions 107 et de la couche isolante 111. Dans l'exemple représenté, la couche isolante 111 affleure la face des régions 107 opposée au substrat 103 (la face supérieure des régions 107, dans l'orientation de la figure 1D).

Par ailleurs, la structure est amincie, par exemple par meulage, du côté de la face 103B du substrat 103, de sorte à exposer des parties de la couche isolante 111 remplissant le fond des tranchées 109. Les parties de la couche isolante 111 situées à l'intérieur des tranchées 109 affleurent ainsi la face 103B du substrat 103. À titre d'exemple, la structure est temporairement reportée sur un substrat de support, ou poignée, du côté de la face 103T du substrat 103 préalablement à l'amincissement de la structure du côté de la face 103B, le substrat de support étant ensuite éliminé postérieurement à l'amincissement.

La figure 1E illustre plus précisément une structure obtenue, à partir de la structure de la figure 1D, à l'issue d'une étape dans laquelle une autre couche isolante 113 est déposée du côté de la face 103B du substrat 103 et dans laquelle le substrat 103 est découpé sur toute son épaisseur pour séparer, ou individualiser, les composants électroniques 100.

Dans l'exemple représenté, la couche isolante 113 est située sur et en contact avec la face 103B du substrat 103 et avec les parties de la couche isolante 111 affleurant la face 103B du substrat 103. La couche 113 est par exemple en une résine, par exemple une résine de moulage destinée à faire partie de boîtiers des composants électroniques 100. À titre d'exemple, les couches isolantes 111 et 113 sont en le même matériau.

Dans l'exemple représenté, la structure comprend des tranchées 115 s'étendant verticalement dans l'épaisseur des régions conductrices 107 depuis la face des régions conductrices 107 opposée au substrat 103 (la face supérieure des régions conductrices 107, dans l'orientation de la figure 1E). Dans cet exemple, les tranchées 115 présentent une hauteur, ou profondeur, inférieure à la hauteur, ou épaisseur, des régions conductrices 107. En vue de dessus, les tranchées 115 et 117 entourent chaque composant électronique 100.

Dans l'exemple illustré, la structure comprend en outre des tranchées 117 présentant une largeur inférieure à celle des tranchées 115. Dans l'exemple représenté, chaque tranchée 117 s'étend verticalement depuis le fond de l'une des tranchées 115 à travers la région conductrice 107, le substrat 103 et la couche isolante 113. Les tranchées 117 présentent ainsi une extrémité débouchant du côté de la face 103B du substrat 103. Dans l'exemple illustré, les tranchées 117 présentent une largeur strictement inférieure à celle des parties de la couche isolante 111 situées à l'intérieur des tranchées 109.

Les tranchées 115 sont par exemple réalisées avant les tranchées 117. À titre d'exemple, les tranchées 115 et 117 sont formées par sciage.

Dans l'exemple représenté, les tranchées 117 délimitent des parties du substrat 103 faisant par exemple chacune partie d'une puce de circuit intégré 119, ou puce électronique, de l'un des composants électroniques 100.

La figure 2 est une vue en coupe, schématique et partielle, d'un dispositif électronique 200 comprenant un composant électronique 100 selon un mode de réalisation.

Dans l'exemple représenté, le dispositif électronique 200 comprend un substrat de support et d'interconnexion 203, par exemple une carte de circuit imprimé. Dans l'exemple illustré, des éléments de reprise de contact 205 sont situés sur et en contact avec une face du substrat de support et d'interconnexion 203 (la face supérieure du substrat de support et d'interconnexion 203, dans l'orientation de la figure 2). Les éléments de reprise de contact 205 sont par exemple connectés à des pistes conductrices formées sur le substrat 203 et/ou à des vias conducteurs formés dans l'épaisseur du substrat 203. À titre d'exemple, les éléments de reprise de contact 205 sont des plots conducteurs, par exemple des plots en un métal, par exemple le cuivre, ou en un alliage métallique.

Dans l'exemple illustré, le composant électronique 100 est fixé au substrat de support et d'interconnexion 203 par des régions conductrices 207 interposées entre le composant 100 et le substrat 203. Dans cet exemple, chaque région conductrice 207 est plus précisément interposée entre l'une des régions conductrices 107 du composant électronique 100 et l'un des éléments de reprise de contact 205 du substrat de support et d'interconnexion 203. Chaque élément de reprise de contact 205 du substrat de support et d'interconnexion 203 est ainsi connecté à l'un des éléments de reprise de contact 105 du composant électronique 100 par l'intermédiaire de l'une des régions conductrices 207 et de l'une des régions conductrices 107.

Les régions conductrices 207 sont en un alliage métallique présentant un point de fusion strictement inférieur à celui de l'alliage métallique des régions conductrices 107. À titre d'exemple, les régions conductrices 207 sont en un alliage sans plomb, par exemple un alliage d'étain, d'argent et de cuivre (alliage Sn-Ag-Cu) également connu sous l'acronyme SAC.

Dans l'exemple représenté, les régions conductrices 207 revêtent une face des régions conductrices 107 située du côté du substrat de support et d'interconnexion 203 (la face inférieure des régions conductrices 107, dans l'orientation de la figure 2). En outre, dans cet exemple, les régions conductrices 207 revêtent une partie du flanc des régions conductrices 107, c'est-à-dire mouillent les flancs des régions conductrices 107.

La figure 2 illustre un exemple dans lequel le dispositif électronique 200 comprend un seul composant électronique 100. Cet exemple n'est toutefois pas limitatif, le dispositif électronique 200 pouvant, à titre de variante, comprendre un nombre quelconque de composants électroniques du type du composant 100. À titre d'exemple, le dispositif électronique 200 est intégré dans un véhicule automobile, le composant électronique 100 mettant par exemple en œuvre une fonction de protection contre des décharges électrostatiques auxquelles le dispositif électronique 200 est susceptible d'être exposé.

Un avantage du composant électronique 100 tient au fait que la présence des régions conductrices 107 à forte teneur en bismuth permettent d'obtenir des flancs mouillables. Cela favorise la mise en œuvre d'opérations d'inspection de la brasure du composant 100 sur le substrat de support et d'interconnexion 203. Un autre avantage lié à l'utilisation de régions conductrices 107 en un alliage métallique à forte teneur en bismuth réside dans le fait que cela permet d'éviter des problèmes de pontage, ou d'interconnexion, involontaire entre des puces de circuit intégré adjacentes lors de l'étape de refusion du matériau des régions conductrices 107 préalable à l'étape de découpe visant à individualiser les puces de circuit intégré. Cela provient notamment du fait que l'alliage métallique à forte teneur en bismuth présente, à l'état liquide, une tension superficielle supérieure à celle des alliages connus, notamment l'alliage SAC.

Par ailleurs, l'alliage à forte teneur en bismuth présente l'avantage de pouvoir être utilisé en remplacement d'alliages coûteux, par exemple l'alliage d'or et d'étain, pour la réalisation de brasures en un matériau présentant un point de fusion strictement supérieur à celui de l'alliage SAC. Dans ce cas, l'alliage à forte teneur en bismuth revêt par exemple au moins partiellement une face inférieure d'une puce de circuit intégré superposée à une autre puce de circuit intégré, par exemple une puce du type de la puce 119 précédemment décrite en relation avec la figure 1E.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus. En particulier, la teneur en bismuth dans l'alliage métallique des régions conductrices 107 peut être ajustée en fonction de l'application, par exemple afin d'obtenir un compromis entre une augmentation de la tension superficielle de l'alliage à l'état liquide, obtenue en augmentant la teneur en bismuth dans l'alliage, et une augmentation de la mouillabilité des flancs des composants électroniques 100, obtenue en diminuant la teneur en bismuth dans l'alliage.

## Revendications

1. Composant électronique (100) comprenant :
- une puce de circuit intégré (119) ;
- un boîtier (111, 113) entourant la puce de circuit intégré ; et
- au moins une première région conductrice (107) revêtant au moins partiellement une face de la puce de circuit intégré, la première région conductrice comprenant un alliage comportant majoritairement du bismuth, dans lequel chaque première région conductrice (107) est revêtue d'une deuxième région conductrice (207) en un alliage métallique présentant un point de fusion strictement inférieur à celui de l'alliage de chaque première région conductrice (107).

2. Composant (100) selon la revendication 1, dans lequel l'alliage présente une teneur en bismuth supérieure à 80 %, de préférence égale à environ 90 %.

3. Composant (100) selon la revendication 1 ou 2, dans lequel l'alliage comprend en outre au moins un élément d'addition choisi parmi l'argent, le nickel et l'étain.

4. Composant (100) selon la revendication 3, dans lequel l'alliage présente une teneur en ledit au moins un élément d'addition inférieure à 10 %, de préférence égale à environ 5 %.

5. Composant (100) selon l'une quelconque des revendications 1 à 4, dans lequel l'alliage présente :
- une teneur en bismuth égale à environ 90 % ;
- une teneur en argent égale à environ 5 % ; et
- une teneur en nickel égale à environ 5 %.

6. Composant (100) selon l'une quelconque des revendications 1 à 5, dans lequel l'alliage présente un point de fusion compris entre 270 et 290 °C.

7. Dispositif électronique (200) comprenant :
- un substrat de support et d'interconnexion (203) ;
- au moins un élément de reprise de contact (205) situé sur une face du substrat de support et d'interconnexion ;
- au moins un composant électronique (100) selon l'une quelconque des revendications 1 à 6 ; et
- la deuxième région conductrice (207) interposée entre chaque élément de reprise de contact et chaque première région conductrice (107) du composant électronique.

8. Dispositif (200) selon la revendication 7, dans lequel la deuxième région conductrice (207) revêt un flanc du composant électronique (100).

9. Dispositif (200) selon la revendication 7 ou 8, dans lequel la deuxième région conductrice (207) est en un alliage d'étain, d'argent et de cuivre.

10. Véhicule automobile comprenant au moins un dispositif (200) selon l'une quelconque des revendications 7 à 9.

11. Procédé de fabrication d'un composant électronique (100) comprenant une puce de circuit intégré (119) et un boîtier (111, 113) entourant la puce de circuit intégré, le procédé comprenant l'étape de revêtir au moins partiellement une face de la puce de circuit intégré d'une première région conductrice (107) comprenant un alliage comportant majoritairement du bismuth,
dans lequel la première région conductrice (107) est revêtue d'une deuxième région conductrice (207) en un alliage métallique présentant un point de fusion strictement inférieur à celui de l'alliage de chaque première région conductrice (107).

## Patentansprüche

1. Ein elektronisches Bauteil **(100)**, das Folgendes aufweist:
einen integrierten Schaltungschip **(119)**;
ein Gehäuse **(111, 113)**, das den integrierten Schaltungschip umgibt; und
wenigstens einen ersten leitfähigen Bereich **(107)**, der eine Fläche des integrierten Schaltungschips wenigstens teilweise beschichtet, wobei der erste leitfähige Bereich eine Legierung aufweist, die überwiegend Bismut aufweist,
wobei jeder erste leitfähige Bereich **(107)** mit einem zweiten leitfähigen Bereich **(207)** aus einer metallischen Legierung beschichtet ist, die einen Schmelzpunkt aufweist, der strikt niedriger ist als derjenige der Legierung jedes ersten leitfähigen Bereichs **(107)**.

2. Das Bauteil **(100)** nach Anspruch 1, wobei die Legierung einen Bismutgehalt von über 80 % aufweist, vorzugsweise etwa 90 %.

3. Das Bauteil **(100)** nach Anspruch 1 oder 2, wobei die Legierung ferner wenigstens ein Additivelement aufweist, ausgewählt aus Silber, Nickel und Zinn.

4. Das Bauteil **(100)** nach Anspruch 3, wobei die Legierung einen Gehalt des wenigstens einen Additivelements von weniger als 10 % aufweist, vorzugsweise etwa 5 %.

5. Das Bauteil **(100)** nach einem der Ansprüche 1 bis 4, wobei die Legierung Folgendes aufweist:
einen Bismutgehalt von etwa 90 %;
einen Silbergehalt von etwa 5 %; und
einen Nickelgehalt von etwa 5 %.

6. Das Bauteil **(100)** nach einem der Ansprüche 1 bis 5, wobei die Legierung einen Schmelzpunkt zwischen 270 und 290 °C aufweist.

7. Eine elektronische Einrichtung **(200)**, die Folgendes aufweist:
ein Träger- und Verbindungs-Substrat **(203)**;
wenigstens ein Kontaktaufnahmeelement **(205)**, das auf einer Seite des Träger- und Verbindungs-Substrats angeordnet ist;
wenigstens ein elektronisches Bauteil **(100)** nach einem der Ansprüche 1 bis 6; und
den zweiten leitfähigen Bereich **(207)**, der zwischen dem wenigstens einen Kontaktaufnahmeelement und dem wenigstens einen ersten leitfähigen Bereich **(107)** des elektronischen Bauteils angeordnet ist.

8. Die Einrichtung **(200)** nach Anspruch 7, wobei der zweite leitfähige Bereich **(207)** eine Flanke des elektronischen Bauteils **(100)** beschichtet.

9. Die Einrichtung **(200)** nach Anspruch 7 oder 8, wobei der zweite leitfähige Bereich **(207)** aus einer Legierung aus Zinn, Silber und Kupfer hergestellt ist.

10. Ein Kraftfahrzeug, das wenigstens eine Einrichtung **(200)** nach einem der Ansprüche 7 bis 9 aufweist.

11. Ein Verfahren zum Herstellen eines elektronischen Bauteils **(100)**, das einen integrierten Schaltungschip **(119)** und ein Gehäuse **(111, 113)** aufweist, das den integrierten Schaltungschip umgibt, wobei das Verfahren den Schritt des wenigstens teilweisen Beschichtens einer Fläche des integrierten Schaltungschips mit einem ersten leitfähigen Bereich **(107)** aufweist, der eine Legierung aufweist, die überwiegend Bismut aufweist,
wobei der erste leitfähige Bereich **(107)** mit einem zweiten leitfähigen Bereich **(207)** aus einer metallischen Legierung beschichtet ist, die einen Schmelzpunkt aufweist, der strikt niedriger ist als derjenige der Legierung jedes ersten leitfähigen Bereichs **(107)**.

## Claims

1. An electronic component (100) comprising:
an integrated circuit chip (119);
a package (111, 113) surrounding the integrated circuit chip; and
at least a first conductive region (107) at least partially coating one side of the integrated circuit chip, the first conductive region comprising an alloy predominantly comprising bismuth,
wherein each first conductive region (107) is coated with a second conductive region (207) in a metallic alloy having a melting point strictly lower than that of the alloy of each first conductive region (107).

2. The component (100) according to claim 1, wherein the alloy has a bismuth content of over 80%, preferably equal to approximately 90%.

3. The component (100) according to claim 1 or 2, wherein the alloy further comprises at least one additive element selected from silver, nickel and tin.

4. The component (100) according to claim 3, wherein the alloy has a content of said at least one additive element of less than 10%, preferably equal to approximately 5%.

5. The component (100) according to any one of claims 1 to 4, wherein the alloy has:
a bismuth content equal to approximately 90%;
a silver content equal to approximately 5%; and
a nickel content equal to approximately 5%.

6. The component (100) according to any one of claims 1 to 5, wherein the alloy has a melting point of between 270 and 290°C.

7. An electronic device (200) comprising:
a support and interconnection substrate (203);
at least one contact pick-up element (205) located on one face of the support and interconnection substrate;
at least one electronic component (100) according to any one of claims 1 to 6; and
the second conductive region (207) interposed between said at least one contact pick-up element and said at least one first conductive region (107) of the electronic component.

8. The device (200) according to claim 7, wherein the second conductive region (207) coats a flank of the electronic component (100).

9. The device (200) according to claim 7 or 8, wherein the second conductive region (207) is made of an alloy of tin, silver and copper.

10. A motor vehicle comprising at least one device (200) according to any one of claims 7 to 9.

11. A method of manufacturing an electronic component (100) comprising an integrated circuit chip (119) and a package (111, 113) surrounding the integrated circuit chip, the method comprising the step of at least partially coating a face of the integrated circuit chip with a first conductive region (107) comprising an alloy predominantly comprising bismuth,
wherein the first conductive region (107) is coated with a second conductive region (207) in a metallic alloy having a melting point strictly lower than that of the alloy of each first conductive region (107).
